**Europäisches Patentamt**

**European Patent Office**

**Office européen des brevets**

(19)

(11) Numéro de publication: **0 325 808 B1**

(12) **FASCICULE DE BREVET EUROPEEN**

(45) Date de publication de fascicule du brevet: **19.08.92**   (51) Int. Cl.5: **H01L 21/285**, H01L 21/31

(21) Numéro de dépôt: **88202724.6**

(22) Date de dépôt: **30.11.88**

(54) **Procédé pour établir une structure d'interconnexion électrique sur un dispositif semiconducteur au silicium.**

(30) Priorité: **04.12.87 FR 8716873**

(43) Date de publication de la demande:
**02.08.89 Bulletin 89/31**

(45) Mention de la délivrance du brevet:
**19.08.92 Bulletin 92/34**

(84) Etats contractants désignés:
**DE FR GB IT NL**

(56) Documents cités:
**EP-A- 0 139 467**
**EP-A- 0 147 913**
**EP-A- 0 186 296**
**FR-A- 2 059 593**

(73) Titulaire: **N.V. Philips' Gloeilampenfabrieken**
**Groenewoudseweg 1**
**NL-5621 BA Eindhoven(NL)**

(72) Inventeur: **Ellwanger, Russell Craig**
**Groenewoudseweg 1**
**NL-5621 BA Eindhoven(NL)**
Inventeur: **Schmitz, Johannes Elisabeth**
**Groenewoudseweg 1**
**NL-5621 BA Eindhoven(NL)**

(74) Mandataire: **Pinchon, Pierre et al**
**Société Civile S.P.I.D. 156, Boulevard Haussmann**
**F-75008 Paris(FR)**

Rank Xerox (UK) Business Services

## Description

La présente invention concerne un procédé de fabrication d'une structure d'interconnexion électrique sur un dispositif semiconducteur à substrat de silicium, procédé qui comporte notamment les étapes consistant successivement :

- à créer à la surface du dispositif des zones de contact,
- à former des îlots de contact comprenant au moins une couche de siliciure d'un métal réfractaire tel que le titane ou le cobalt, recouvrant les zones de contact,
- à former sur l'ensemble une couche isolante dans laquelle sont pratiquées des ouvertures de contact où se trouvent exposées au moins des portions de la surface desdits îlots de contact,
- à réaliser une configuration métallique d'interconnexion en effectuant d'abord un remplissage au moins partiel des ouvertures de contact par des éléments localisés d'un métal réfractaire tel que le tungstène ou le molybdène, puis en recouvrant l'ensemble d'une couche métallique qui est ensuite découpée dans une configuration déterminée, des parties de cette configuration métallique recouvrant les ouvertures de contact et étant en contact électrique avec lesdits éléments localisés.

Des dispositifs semiconducteurs et notamment des circuits intégrés sont couramment fabriqués en utilisant de l'aluminium ou un alliage d'aluminium en tant que matériau pour la prise de contact avec la surface du silicium et pour établir les structures d'interconnexion. Cependant, une tendance constante de la technique se manifeste en faveur d'un accroissement de la complexité des fonctions intégrées ainsi que de leur rapidité de fonctionnement ce qui amène à donner aux éléments constitutifs de ces fonctions des dimensions de plus en plus petites.

Dans ce contexte, il s'est avéré que l'aluminium présentait de sérieuses limitations d'emploi vis-à-vis de certains procédés de fabrication de circuits à très haute densité d'intégration, au moins en ce qui concerne la prise de contact sur des zones dopées du semiconducteur ayant une très faible épaisseur et des dimensions latérales réduites.

C'est pourquoi, une technique de prise de contacts utilisant un siliciure d'un métal réfractaire, par exemple le siliciure de titane, en tant que matériau pour la prise de contact à la surface du semiconducteur, paraît actuellement préférée dans le domaine de l'intégration à très grande échelle notamment du fait que cette technique permet la création d'îlots de contacts auto-alignés avec les zones de contact prévues à la surface des dispositifs et, dans le cas de transistors MOS, également auto-alignés avec les grilles en silicium polycristallin si on le désire.

En ce qui concerne la réalisation des configurations d'interconnexion de niveau supérieur au premier niveau, les recherches se poursuivent pour déterminer quelles sont les techniques les plus convenables notamment en vue d'effectuer des liaisons électriques (verticales) entre les différents niveaux d'interconnexion, dont les dimensions soient de l'ordre de 1 micromètre de diamètre ou moins. En effet une telle réduction des dimensions est souhaitable pour atteindre les très hautes densités d'intégration envisagées. A ce sujet, une difficulté importante provient du fait que les ouvertures de contact dans la couche isolante de séparation sont relativement profondes par rapport à leur diamètre (rapport profondeur/diamètre voisin de l'unité et même supérieur) et que les technique de métallisation classiques ne sont plus utilisables pour remplir convenablement des ouvertures de contact ayant une telle géométrie.

Parmi les méthodes envisagées pour résoudre cette difficulté, il a été proposé de réaliser la configuration métallique d'interconnexion en deux étapes, une première étape visant à remplir au moins substantiellement les ouvertures de contact avec des éléments localisés d'un métal réfractaire, tungstène ou molybdène, obtenus par exemple par croissance sélective ou encore par dépôt à propriété uniformément recouvrante suivi d'un décapage partiel, et une deuxième étape consistant simplement à recouvrir la structure d'une couche métallique et d'y découper la configuration désirée.

Des résultats d'essais relatifs à plusieurs procédés de prise de contact et notamment en vue de mettre en oeuvre le procédé mentionné en préambule, sont publiés dans un article intitulé : "The contact properties to $TiSi_2$ and the adhesion within sub-micron contact holes of etched back CVD W/adhesion layer films", de R.C. Ellwanger, J.E. Schmitz, R.A. Wolters et A.J. van Dijk. "Proceedings of the workshop on tungsten and other refractory metals for VLSI applications", II, 1986.

Dans le procédé en question, l'opération consistant à réaliser les ouvertures de contact dans la couche isolante est assez critique.

En effet, l'arrêt du décapage dans le fond de ces ouvertures est constitué par la couche de siliciure dont la sélectivité de décapage vis à vis de l'oxyde de la couche isolante n'est pas très élevée. Il y a donc des risques que la couche de siliciure soit endommagées lors du décapage des ouvertures de contact.

La présente invention a notamment pour but de remédier à cette difficulté et de fournir un procédé dans lequel l'opération de décapage des ouvertures de contact est moins critique et préserve l'intégrité de la couche de siliciure en contact avec le matériau semiconducteur.

En effet, selon l'invention, un procédé de fabrication d'une structure d'interconnexion électrique sur un dispositif semiconducteur à substrat de silicium, procédé qui comporte notamment les étapes consistant successivement :

- à créer à la surface du dispositif des zones de contact,
- à former des îlots de contact comprenant au moins une couche de siliciure d'un métal réfractaire tel que le titane, ou le cobalt, recouvrant les zones de contact,
- à former sur l'ensemble une couche isolante dans laquelle sont pratiquées des ouvertures de contact où se trouvent exposées au moins des portions de la surface desdits îlots de contact,
- à réaliser une configuration métallique d'interconnexion en effectuant d'abord un remplissage au moins partiel des ouvertures de contact par des éléments localisés d'un métal réfractaire tel que le tungstène ou le molybdène, puis en recouvrant l'ensemble d'une couche métallique qui est ensuite découpée dans la configuration déterminée, des parties de cette configuration métallique recouvrant les ouvertures de contact et étant en contact électrique avec lesdits éléments localisés, est caractérisé en ce qu'avant d'établir la couche isolante, les îlots de contact sont recouverts d'une couche métallique complémentaire, obtenue par croissance sélective de tungstène ou de molybdène, qui est localisée auxdits îlots.

Ainsi lors du décapage des ouvertures de contact dans la couche isolante, la profondeur du décapage à réaliser est limitée par la couche métallique complémentaire. Or la sélectivité de décapage du matériau isolant, - dioxyde de silicium par exemple - vis-à-vis du tungstène ou du molybdène est excellente, de sorte que l'opération de décapage peut être prolongée sans crainte d'une attaque notable de la couche métallique complémentaire dans le fond de ces ouvertures. Ce procédé permet d'effectuer en toute sécurité des ouvertures de contact qui, sur le même substrat, présentent des limites de profondeur différentes comme cela résulte d'une opération dite de planarisation de la couche isolante.

D'autre part, comme la couche métallique complémentaire est obtenue directement sous une forme localisée, elle ne nécessite pas l'emploi d'un masque particulier de gravure. On peut également observer que cette couche métallique complémentaire a un rôle qui n'impose pas un contrôle rigoureux de son épaisseur.

Enfin, la structure formée par l'association de la couche métallique complémentaire et des éléments localisés en métal réfractaire présente en raison de sa forme, une meilleure résistance mécanique contre les contraintes et notamment les contraintes d'origine thermique.

En pratique, l'épaisseur de la couche métallique complémentaire est choisie entre 20 et 150nm et de préférence entre 50 et 100nm.

Dans un premier mode particulier de mise en oeuvre, le procédé selon l'invention est caractérisé en ce que ayant choisi le titane en tant que métal réfractaire pour la réalisation de ladite couche de siliciure, on forme à sa surface une couche de nitrure de titane que l'on utilise comme base pour la croissance sélective de la couche métallique complémentaire.

De préférence cette couche de nitrure de titane est formée par un traitement de conversion en surface de la couche de siliciure de titane à une température comprise entre 700 et 1000°C, sous atmosphère d'azote. On réalise ainsi une base convenable pour la croissance de la couche métallique complémentaire au moyen du traitement thermique qui sert en même temps au recuit de la couche de siliciure de titane.

Selon ce mode de mise en oeuvre, la couche métallique complémentaire est de préférence réalisée par la méthode de dépôt chimique en phase vapeur, à une pression réduite comprise entre 0,05 et 2 torr (6,6 à 266 Pa), utilisant la réduction par l'hydrogène de l'hexafluorure de tungstène (ou de l'hexafluorure de molybdène), à une température comprise entre 300 et 500°C et un rapport de débit gazeux hexafluorure/hydrogène compris entre 1/1000 et 1/5.

Dans un deuxième mode particulier de mise en oeuvre de l'invention, la protection de la couche de siliciure de titane par une couche de nitrure de titane avant le dépôt de la couche métallique complémentaire n'est plus nécessaire.

Il se caractérise par le fait que dans le procédé de réaction chimique en phase vapeur (LPCVD) qui vient d'être mentionné, on introduit en outre un débit de silane ($SiH_4$) dont la valeur par rapport au débit de l'hexafluorure de tungstène (ou de molybdène) est compris entre 1/5 et 3/1.

La description qui va suivre en regard des dessins annexés, le tout donné à titre d'exemple non limitatif, fera bien comprendre comment l'invention peut être réalisée.

La figure 1 est une coupe schématique et partielle montrant une structure d'interconnexion de circuit intégré susceptible d'être obtenue par le procédé selon l'invention.

Les figures 2 à 6 illustrent par des vues partielles, en coupe, différentes étapes du procédé selon l'invention pour la prise de contacts électriques sur un dispositif semiconducteur.

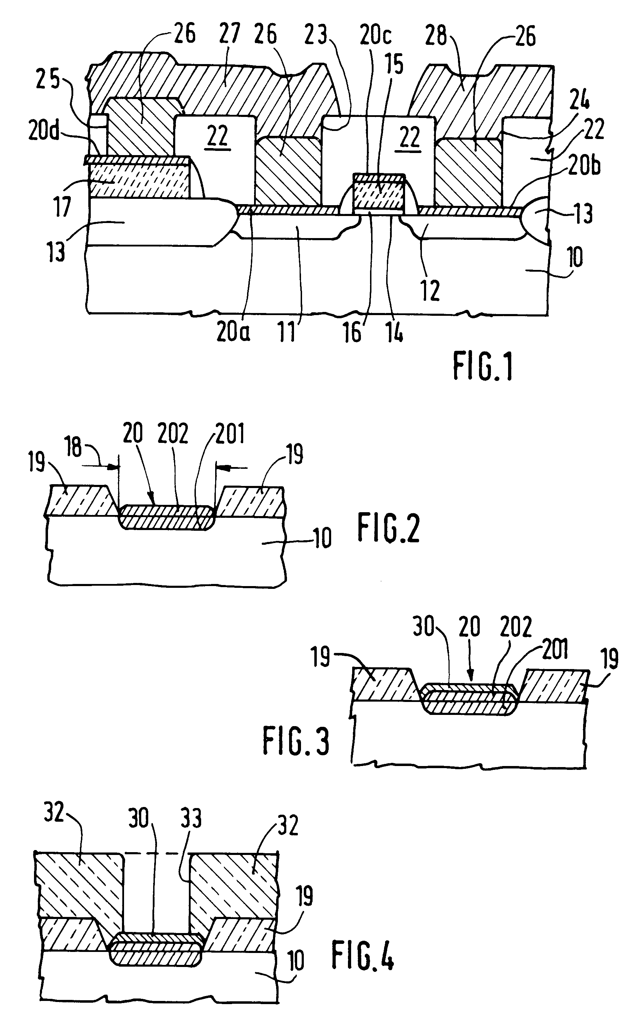

La figure 1 indique un exemple de structure d'interconnexion effectuant la prise de contacts électriques dans un circuit intégré au silicium, à transistors MOS. Un substrat 10 d'un premier type de conductivité, porte à sa surface des régions dopées de source et de drain 11, 12, d'un deuxième type de conductivité, opposé au premier. Ces régions dopées 11 et 12 ont un pourtour délimité par une couche localisée d'oxyde de champ 13 et sont séparées entre elles par un étroit canal 14 surmonté d'une grille 15 de commande en silicium polycristallin fortement dopé. La grille 15 est isolée du matériau semiconducteur du canal 14 par une couche d'oxyde de grille 16.

Des portions de la couche de silicium polycristallin ayant servi à créer la grille 15 peuvent être maintenues au dessus de l'oxyde de champ 13, pour établir certaines liaisons électriques ; c'est le cas de la bande de liaison représentée en 17. A la surface du dispositif en cours de formation, des zones de contact on été réalisées qui exposent la majeure partie de la surface des régions dopées 11 et 12 ainsi que la surface des grilles 15 et des bandes de liaison 17. Ensuite ont été formés des îlots de contact 20a à 20d comprenant au moins une couche de siliciure d'un métal réfractaire tel que le titane ou le cobalt, et qui ont été obtenus par auto-alignement avec les zones de contact, selon une technique bien connue des spécialistes du domaine.

Une couche isolante 22 comporte des ouvertures de contact 23, 24, 25 dont le fond débouche sur des îlots de contact déterminés 20a, 20b, 20d.

Enfin une configuration d'interconnexion complète la structure du dispositif représenté, cette configuration comportant d'une part des éléments localisés 26 de tungstène ou de molybdène remplissant au moins partiellement les ouvertures de contact 23, 24, 25, et d'autre part des portions 27, 28 d'une couche métallique dite de deuxième niveau, qui peut être réalisée en aluminium par exemple, découpée en une configuration déterminée, et qui recouvre les éléments localisés 26 en vue d'effectuer les liaisons électriques désirées avec les îlots de contact 20a, 20b, 20d.

Comme il va être exposé dans ce qui suit, le procédé selon l'invention vise à réaliser une structure d'interconnexion notamment du type schématisé à la figure 1 dans lequel, avant d'établir la couche isolante 22, les îlots de contact 20a, 20b, 20c, 20d sont recouverts d'une couche métallique complémentaire obtenue par croissance sélective de tungstène ou de molybdène et qui se trouve de ce fait, localisée à ces îlots.

Le procédé selon l'invention est décrit en référence aux figures 2 à 6. Il est à noter que l'exemple illustré sur ces figures doit être compris comme étant très général et désignant toute espèce de prise de contact sur un dispositif semiconducteur, que ce soit un contact avec le substrat, avec une région dopée portée par ce substrat, ou encore avec une couche de matériau polycristallin. La figure 2 montre de manière schématique et simplifiée un îlot de contact 20 disposé dans une zone de contact 18 délimitée à la surface d'un substrat semiconducteur 10 au moyen d'une couche diélectrique 19.

L'îlot de contact 20 est obtenu de façon auto-alignée avec la zone de contact 18 en déposant une couche d'un métal réfractaire tel que le titane, sur l'ensemble de la structure, puis, par un traitement thermique convenable, à faire localement réagir la couche de titane avec les portions de surface de silicium qui ne sont pas couvertes par la couche diélectrique 19, et former un siliciure de titane à l'emplacement des zones de contact 18, puis enfin en enlevant par décapage sélectif le reste de la couche de titane n'ayant pas réagi. Il est connu et pratiquement nécessaire, à ce stade du procédé de stabiliser la composition de la couche de siliciure de titane en contact avec le matériau de la zone de contact par un deuxième traitement thermique, effectué de préférence sous atmosphère d'azote. C'est pourquoi l'îlot de contact 20 se compose finalement d'une couche de siliciure de titane 201 surmontée d'une mince couche de nitrure de titane 202 obtenue au cours du traitement mentionné par l'action de l'azote sur le siliciure de titane.

A titre indicatif, un traitement d'une durée de 10 secondes à 850°C, sous azote, conduit à la formation d'une couche de nitrure de titane 202, de 6 à 8nm d'épaisseur, à la surface d'une couche de siliciure de titane 201 de l'ordre de 30nm d'épaisseur.

On procède alors à une croissance sélective de tungstène ayant pour objet de recouvrir les îlots de contact 20 par une couche métallique complémentaire, relativement mince.

Dans cette opération, la couche de nitrure de titane 202 sert de base de nucléation pour la croissance du tungstène, alors que la couche diélectrique 19 inhibe au contraire cette croissance. Ainsi, la couche métallique complémentaire 30 se trouve localisée aux îlots de contact 20 comme indiqué à la figure 3, sans avoir recours à une opération de photomasquage. Le procédé de croissance sélective du tungstène est connu en tant que tel. Il utilise de préférence la méthode de dépôt en phase vapeur utilisant la réaction chimique de réduction du fluorure de tungstène ($WF_6$) par l'hydrogène ($H_2$), à une température comprise entre 300°C et 500°C, et sous une pression réduite de l'ordre de 6,6 à 266Pa (0,05 à 2 torr). Les débits gazeux de $WF_6$ et d'$H_2$, introduits lors de la réaction, sont choisis dans un rapport compris entre 1/1000 et 1/5.

La couche métallique complémentaire 30 peut encore, si on le désire, être réalisée par croissance sélective de molybdène selon des conditions opératoires très voisine de celles indiquées pour le tungstène. Dans la réaction indiquée, de réduction d'un hexafluorure de tungstène ou de molybdène par l'hydrogène, la couche de siliciure de titane 201 se trouverait attaquée si elle n'était pas protégée par une couche de nitrure de titane 202. Cette protection toutefois n'est plus indispensable et la couche de nitrure de titane 202 pourrait être omise dans une variante du procédé de dépôt chimique en phase vapeur selon laquelle la réduction de l'hexafluorure est complétée par l'introduction d'un débit de silane ($SiH_4$) dans les gaz de réaction, de valeur suffisamment faible, comparée au débit de l'hexafluorure, pour que la sélectivité de croissance soit préservée.

Lorsque le rapport entre le débit de silane et le débit de l'hexafluorure utilisé est choisi dans la gamme de 1/5 à 3/1, un rapport de l'ordre de 1/1 étant particulièrement favorable, la sélectivité du dépôt est bien conservée, l'attaque du siliciure de titane (ou du silicium) est évitée alors que l'incorporation de silicium dans le métal déposé reste si faible qu'elle est difficilement mesurable et peut être considérée comme nulle, en pratique.

Bien qu'en réalité l'épaisseur de la couche métallique complémentaire 30 ne soit pas particulièrement critique, elle est choisie en général entre 20 et 150nm et de préférence entre 50 et 100nm.

Au delà de 150nm d'épaisseur, on introduit un relief de topographie indésirable à la surface du dispositif et la durée de l'opération de dépôt est prolongée inutilement. En dessous de 20nm d'épaisseur, la couche métallique complémentaire 30 ne remplit plus complètement son rôle de barrière de décapage et peut présenter des discontinuités résultant de la phase initiale de croissance.

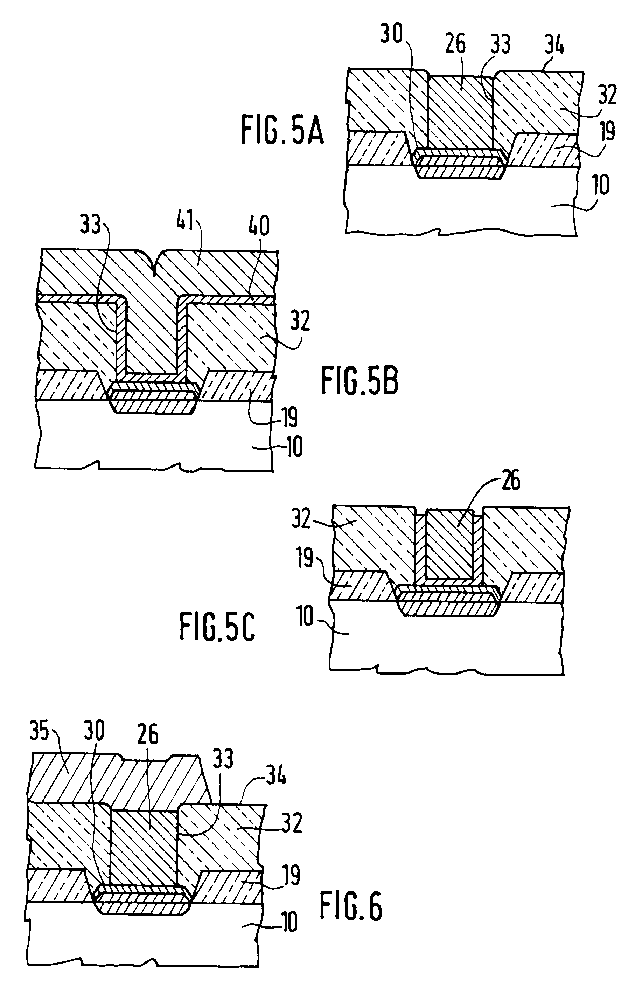

Comme représenté à la figure 4 on forme ensuite sur l'ensemble de la structure une couche isolante 32, par exemple en bioxyde de silicium, en utilisant toute méthode convenable par exemple la méthode de dépôt en phase vapeur utilisant l'oxydation d'un composé du silicium.

Il peut être avantageux à ce stade du processus, de faire subir à la couche isolante 32 une opération dite de planarisation qui a pour but de rendre sa surface externe pratiquement plane alors que cette couche isolante repose sur une structure ayant un relief prononcé.

A l'aide d'une opération de photomasquage, on procède au décapage d'ouvertures de contact 33 dans la couche isolante 32 en utilisant de préférence la technique dénommée gravure ionique réactive, qui permet d'obtenir des ouvertures de très petit diamètre, ayant des bords pratiquement verticaux. L'emplacement des ouvertures de contact 33 est tel que ces ouvertures mettent à découvert une portion de la surface de la couche métallique complémentaire 30 recouvrant les îlots de contact. La gravure ionique de la couche isolante 32 utilise de préférence le mélange gazeux $CF_4 + O_2$ ionisé comme milieu chimique d'attaque.

Dans ce processus la sélectivité de décapage de l'oxyde de silicium vis-à-vis du tungstène ou du molybdène dépasse un rapport de 30 : 1 de sorte que la couche métallique complémentaire 30 fournit un arrêt de décapage très efficace.

Dans le procédé de l'art antérieur, la gravure de la couche isolante 32 se termine sur un îlot de contact formé d'une couche double de nitrure de titane-siliciure de titane. La sélectivité de décapage de l'oxyde de silicium par rapport à ces matériaux n'est que d'un rapport voisin de 10 : 1. Le procédé selon l'invention permet donc de terminer le décapage des ouvertures de contact 33 sans risque de sous-gravure excessive et de dégradation de la couche de siliciure de titane. Cet avantage est particulièrement important lorsque sur un même substrat, des ouvertures de contact de différentes profondeurs doivent être décapées simultanément ainsi que cela a été représenté à la figure 1 pour les ouvertures de contact 23 et 25. Le masque de laque photosensible ayant servi à définir les ouvertures de contact 33 (non représenté sur la figure), est éliminé par exemple au moyen d'un décapage par plasma d'oxygène.

La structure au stade représenté à la figure 4 est alors soumise à un nettoyage complémentaire de sa surface utilisant les bains chimique usuels en la matière, comme par exemple, un trempage dans l'acide nitrique puis dans de l'acide fluorhydrique dilué, suivi d'un rinçage soigneux dans de l'eau désionisée et d'un séchage par centrifugation.

L'opération suivante a pour but de remplir, au moins pour une partie substantielle de leur volume, les ouvertures de contact 33 par des éléments localisés d'un métal réfractaire tel que le tungstène ou le molybdène.

Des éléments localisés 26 tels qu'illustrés à la figure 5A peuvent être obtenus par un procédé de croissance sélective de tungstène ou de molybdène dans des conditions opératoires qui sont sensiblement les mêmes que pour la réalisation de la couche métallique complémentaire 30.

De préférence on utilisera le même métal, tungstène par exemple, pour former la couche métallique complémentaire 30 et les éléments localisés 26, ceci pour des raisons de simplicité et d'économie d'équipements notamment.

Toutefois, cela n'est pas indispensable et on pourrait également réaliser la couche métallique complémentaire 30 en molybdène et faire croître ensuite des éléments localisés 26 en tungstène, ou inversement si on le désire, en fonction de circonstances particulières. Dans tous les cas, la surface métallique de la couche complémentaire 30 qui est exposée dans les ouvertures de contact 33 sert de base de nucléation pour la croissance sélective des éléments localisés 26, alors que sur la surface libre 34 de la couche isolante 32 la croissance ne se produit pas.

Dans une application typique de circuit à haute intégration, les ouvertures de contact 33 ont un diamètre de 0,8μm et une profondeur qui peut varier de 0,5 à 0,9μm en fonction de la position de ces ouvertures.

La durée de la croissance est déterminée de manière à ce que les ouvertures de contact les moins profondes soient remplies à l'excès et présentent des éléments localisés 26 dont le niveau supérieur forme une excroissance qui dépasse un peu le niveau de la couche isolante environnante et qui s'élargit latéralement mais toutefois sans que cela soit gênant pour le fonctionnement du dispositif.

Le cas d'une telle ouverture de contact remplie à l'excès est représenté à la figure 1 pour l'ouverture de contact 25. Les ouvertures de contact les plus profondes, au contraire, pendant le même dépôt, ne sont pas remplies complètement par les éléments localisés 26 comme cela a été représenté pour les ouvertures de contact 23 et 24 de la figure 1.

Ceci ne représente pas un inconvénient sérieux puisque la partie non remplie d'une telle ouverture de contact a un rapport d'aspect (profondeur/diamètre) qui est maintenant très inférieur à l'unité et dont le remplissage ultérieur par des techniques classiques de métallisation peut facilement être obtenu.

La réalisation des éléments localisés 26 est obtenue de manière directe et économique par le procédé de croissance sélective qui vient d'être mentionné. Cela n'est toutefois pas essentiel au regard de l'invention qui est basée essentiellement sur le recouvrement des îlots de contact par une couche complémentaire 30 de tungstène ou de molybdène.

Les éléments localisés 26 peuvent encore être obtenus de manière indirecte, par exemple selon un processus qui va être décrit en se référant aux figures 5B et 5C.

Comme représenté à la figure 5B, on dépose sur toute la surface, y compris la surface intérieure des ouvertures de contact 33 une couche d'adhésion 40, qui est mince vis-à-vis des dimensions des ouvertures de contact, par exemple 100nm d'un alliage de titane-tungstène (10%Ti, 90%W en poids).

Il est important d'utiliser à cet effet un procédé de dépôt comme la pulvérisation cathodique qui assure une couverture pratiquement conforme de la surface, indépendamment de son relief, et dont l'épaisseur est sensiblement constante même à l'intérieur des ouvertures de contact.

Sur la couche d'adhésion 40 on fait croître ensuite une couche de remplissage 41 en tungstène en utilisant également un procédé de dépôt à propriété de recouvrement conforme, comme le procédé de dépôt en phase vapeur, à pression réduite. L'épaisseur de la couche de remplissage 41 est ici choisie suffisante pour remplir entièrement les ouvertures de contact 33 c'est-à-dire qu'elle est d'une valeur qui est au minimum de la moitié du diamètre de ces ouvertures.

La couche d'adhésion et la couche de remplissage sont ensuite éliminées de la surface de la couche isolante 32 pour ne laisser subsister que les portions de ces couches qui sont situées à l'intérieur des ouvertures de contact 33 et forment ainsi des éléments localisés métalliques 26 comme indiqué à la figure 5C. Cette opération peut être réalisée par décapage dans un plasma de $SF_6$ qui attaque plus vite le tungstène et l'alliage titane-tungstène que l'oxyde de silicium.

L'élément localisé 26 fournit une partie d'une configuration métallique d'interconnexion. Comme indiqué figure 6 l'autre partie complémentaire, est réalisée en recouvrant la surface 34 du dispositif d'une couche métallique 35 dont les portions autres que celles de la configuration désirée sont éliminées par un décapage sélectif, localisé au moyen d'un masque de laque photosensible par exemple.

La surface 34 sur laquelle repose la couche métallique 35 a, de préférence, été rendue sensiblement plane, de sorte que cette couche métallique 35 peut être obtenue sans difficulté en utilisant des techniques courantes. De nombreux métaux peuvent convenir pour réaliser cette opération et le choix sera guidé par les exigences d'adhérence mécanique à la surface de la couche isolante 32, par la recherche d'un minimum de conductivité électrique, et d'une bonne résistance au phénomène d'électromigration. A titre d'exemple, une couche d'aluminium ou d'un alliage d'aluminium-cuivre, de 0,8 à 1 μm d'épaisseur convient très bien. Bien entendu, des parties de la couche métallique 35 recouvrent les ouvertures de contact 33 pour y assurer la liaison électrique avec les éléments localisés 26.

Bien que ceci n'a pas été réprésenté sur les figures, on peut compléter le dispositif, si on le désire, et en fonction de sa complexité, par au moins une configuration métallique d'interconnexion supplémentaire, établie à un niveau supérieur.

Le procédé selon l'invention n'est pas limité à la fabrication d'une structure d'interconnexion sur un circuit intégré à transistors MOS. Il vise plus généralement la prise de contacts sur toute sorte de dispositifs semiconducteurs à substrat de silicium et de préférence lorsqu'on désire utiliser des zones de contact de très petites dimensions et y pratiquer des îlots de contact en siliciure d'un métal réfractaire autoalignés avec lesdites zones de contact.

## Revendications

1. Procédé de fabrication d'une structure d'interconnexion électrique sur un dispositif semiconducteur à substrat de silicium, procédé qui comporte notamment les étapes consistant successivement :
   - à créer à la surface du dispositif des zones de contact,
   - à former des îlots de contact comprenant au moins une couche de siliciure d'un métal réfractaire tel que le titane ou le cobalt, recouvrant les zones de contact.
   - à former sur l'ensemble une couche isolante dans laquelle sont pratiquées des ouvertures de contact où se trouvent exposées au moins des portions à la surface desdits îlots de contact,
   - à réaliser une configuration métallique d'interconnexion en effectuant d'abord un remplissage au moins partiel des ouvertures de contact par des éléments localisés d'un métal réfractaire tel que le tungstène ou le molybdène, puis en recouvrant l'ensemble d'une couche métallique qui est ensuite découpée dans une configuration déterminée, des parties de cette configuration métallique recouvrant les ouvertures de contact et étant en contact électrique avec lesdits éléments localisés, caractérisé en ce qu'avant d'établir la couche isolante, les îlots de contact sont recouverts d'une couche métallique complémentaire obtenue par croissance sélective de tungstène ou de molybdène, qui est localisée auxdits îlots.

2. Procédé selon la revendication 1 caractérisé en ce que l'épaisseur de ladite couche métallique complémentaire est choisie entre 20 et 150nm et de préférence entre 50 et 100nm.

3. Procédé selon l'une des revendications 1 ou 2, caractérisé en ce que ayant choisi le titane en tant que métal réfractaire pour la réalisation de ladite couche de siliciure, on forme à sa surface une couche de nitrure de titane que l'on utilise comme base pour la croissance sélective de la couche métallique complémentaire.

4. Procédé selon la revendication 3 caractérisé en ce que ladite couche de nitrure de titane est formée par un traitement de conversion en surface de la couche de siliciure de titane à une température comprise entre 700 et 1000°C, sous atmosphère d'azote.

5. Procédé selon l'une quelconque des revendications 1 à 4, caractérisé en ce que la couche métallique complémentaire est réalisée par la méthode de dépôt chimique en phase vapeur, à une pression réduite comprise entre 6,6 et 266Pa, utilisant la réduction par l'hydrogène de l'hexafluorure de tungstène (ou de l'hexafluorure de molybdène), à une température comprise entre 300 et 500°C et un rapport de débit gazeux hexafluorure/hydrogène compris entre 1/1000 et 1/5.

6. Procédé selon la revendication 5 caractérisé en ce que dans les gaz de réaction du dépôt chimique précité on introduit en outre un débit de silane dont la proportion vis-à-vis du débit d'hexafluorure est dans un rapport choisi entre 1/5 et 3/1.

## Claims

1. A method of manufacturing a structure of electrical interconnections on a semiconductor device having a silicon substrate, this method comprising especially the following successive steps:
   - producing contact zones at the surface of the semiconductor device,
   - forming contact islands comprising at least one layer of a silicide of a refractory metal, such as titanium or cobalt, covering the contact zones,
   - forming on the assembly an insulating layer in which contact openings are provided, in which at least portions of the surface of the said contact islands are exposed,
   - obtaining a metal interconnecting configuration by first carrying out a step of at least partly filling the contact openings with localized elements of a refractory metal, such as tungsten or molybdenum, and by then covering the assembly with a metal layer, which is subsequently cut into a given configuration, parts of this metal configuration covering the contact openings and being in electrical contact with the said localized elements, characterized in that, before the insulating layer is formed, the contact islands are covered by a complementary metal layer obtained by selective growth of tungsten or molybdenum, which is localized at the said islands.

2. A method as claimed in Claim 1, characterized in that the thickness of the said complementary metal layer is chosen to lie between 20 and 150 nm and preferably between 50 and 100 nm.

3. A method as claimed in any one of Claims 1 or 2, characterized in that, when titanium is chosen as the refractory metal for the formation of the said silicide layer, at its surface a layer of titanium nitride is formed which is used as a base for the selective growth of the complementary metal layer.

4. A method as claimed in Claim 3, characterized in that the said titanium nitride layer is formed by a conversion treatment at the surface of the titanium silicide layer at a temperature of between 700 and 1000°C in a nitrogen atmosphere.

5. A method as claimed in any one of Claims 1 to 4, characterized in that the complementary metal layer is formed by the method of chemical deposition from the vapour phase at a reduced pressure of between 6.6 and 266 Pa utilizing the reduction by hydrogen of tungsten hexafluoride (or molybdenum hexafluoride) at a temperature of between 300 and 500°C and a gas flowrate ratio hexafluoride/hydrogen of between 1/1000 and 1/5.

6. A method as claimed in Claim 5, characterized in that moreover a flow of silane, of which the flowrate has a ratio to the flowrate of hexafluoride which is chosen to lie between 1/5 and 3/1, is introduced into the reaction gases of the aforementioned chemical deposition process.

**Patentansprüche**

1. Verfahren zum Herstellen einer elektrischen Verbindungsstruktur auf einer Halbleiteranordnung mit einem Siliziumsubstrat, wobei dieses Verfahren insbesondere die nachfolgenden Verfahrensschritte aufweist:
   - das Herstellen von Kontaktzonen auf der Oberfläche der Anordnung,
   - das Bilden von Kontaktinseln mit mindestens einer die Kontaktzonen bedeckenden Silicidschicht eines hochschmelzenden Metalls, wie Titan oder Kobalt,
   - das Bilden einer Isolierschicht auf dem Gebilde, in der Kontaktöffnungen vorgesehen sind, in denen mindestens Teile der Oberfläche der genannten Kontaktinseln freigelegt sind,
   - das Verwirklichen einer metallischen Konfiguration gegenseitiger Verbindungen, indem zunächst die Kontaktöffnungen durch lokalisierte Elemente eines hochschmelzenden Metalls, wie Wolfram oder Molybdän, mindestens teilweise gefüllt werden, wonach das Ganze mit einer metallischen Schicht bedeckt wird, die danach in eine bestimmte Konfiguration geschnitten wird, wobei Teile dieser metallischen Konfiguration die Kontaktöffnungen bedecken und mit den genannten lokalisierten Elementen in elektrischem Kontakt sind, dadurch gekennzeichnet, daß vor dem Freilegen der Isolierschicht diese Kontaktinseln durch eine auf den genannten Inseln vorhandene komplementäre Metallschicht bedeckt werden, die durch selektives Anwachsen von Wolfram oder Molybdän erhalten worden ist.

2. Verfahren nach Anspruch 1, dadurch gekennzeichnet, daß die Dicke der genannten komplementären Metallschicht zwischen 20 und 150 nm und vorzugsweise zwischen 50 und 100 nm gewählt worden ist.

3. Verfahren nach einem der Ansprüche 1 oder 2, dadurch gekennzeichnet, daß wenn Titan als hochschmelzendes Metall zur Bildung der genannten Silicidschicht gewählt worden ist, auf der Oberfläche desselben eine Titannitridschicht gebildet wird, die als Basis zum selektiven Anwachsen der komplementären Metallschicht benutzt wird.

4. Verfahren nach Anspruch 3, dadurch gekennzeichnet, daß die genannte Titannitridschicht durch eine Umwandlungsbehandlung der Oberfläche der Titansilicidschicht bei einer Temperatur zwischen 700 und 1000°C in einer Stickstoffatmosphäre erhalten wird.

5. Verfahren nach einem der Ansprüche 1 bis 4, dadurch gekennzeichnet, daß die komplementäre Metallschicht nach dem Verfahren der chemischen Abscheidung aus der Dampfphase bei einem verringerten Druck zwischen 6,6 und 266 Pa gebildet wird, wobei Gebrauch gemacht wird von der Reduktion des Wolframhexafluorids (oder des Molybdänhexafluorids) durch Wasserstoff bei einer Temperatur zwischen 300 und 500 ° C und bei einem Gasflußratenverhältnis von Hexafluorid : Wasserstoff zwischen 1 : 1000 und 1 : 5.

6. Verfahren nach Anspruch 5, dadurch gekennzeichnet, daß in den Reaktionsgasen der obengenannten chemischen Abscheidung außerdem eine Silan-Flußrate, deren Verhältnis zu der Hexafluorid-Flußrate zwischen 1 : 5 und 3 : 1 liegt.

FIG.1

FIG.2

FIG.3

FIG.4

FIG.5A

FIG.5B

FIG.5C

FIG.6